(19) Europäisches Patentamt
European Patent Office
Office européen des brevets

(11) EP 4 752 630 A1

(12) EUROPEAN PATENT APPLICATION

(43) Date of publication:
**03.06.2026 Bulletin 2026/23**

(21) Application number: **24216949.8**

(22) Date of filing: **02.12.2024**

(51) International Patent Classification (IPC):
***G03F 7/00*** *(2006.01)*

(52) Cooperative Patent Classification (CPC):
**G03F 7/706841; G03F 7/70625; G03F 7/706837**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
- **DIKIC, Marko**
**5500AH Veldhoven (NL)**
- **BAJALAN, Nastaran**
**5500AH Veldhoven (NL)**
- **SOARES DUARTE, Alex**
**5500AH Veldhoven (NL)**

(74) Representative: **ASML Netherlands B.V.**
**Corporate Intellectual Property**
**P.O. Box 324**
**5500 AH Veldhoven (NL)**

# (54) GRAPH NEURAL NETWORKS FOR EXPLOITING SPATIAL AND SEMANTIC RELATIONS IN METROLOGY DATA

(57) A method of using a graph neural network to process metrology data of a patterned portion of a substrate patterned using a lithographic apparatus, to generate characterization information characterizing the patterned portion of the substrate. The method comprises obtaining metrology data, defining a graph of a graph neural network, defining feature data for each node of the graph based on the metrology data, and at least once generating, using the graph neural network and for each node, corresponding message data for each node associated with the node and updating, for each node, the feature data for the node based on the corresponding one or more message data, to form updated feature data. The method further comprises generating the characterization information from the updated feature data.

Fig. 5

500
504
501
503
506
507
505
502

EP 4 752 630 A1

# Description

## FIELD

The present invention relates to systems and methods for processing metrology data of a patterned portion of at least one substrate patterned using at least one lithographic apparatus, to generate characterization information characterizing the patterned portion. The characterization information may be used for improving the patterning process performed by the at least one lithographic apparatus, e.g. such that substrates patterned subsequently are closer to a design specified by design data.

## BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

After a substrate has been patterned using the lithographic apparatus, it is often desirable to inspect the substrate (i.e. to measure properties of the patterned structure), e.g. to determine whether the produced pattern accurately resembles the intended design. To this end, a metrology system (e.g. optical metrology systems, scanning electron microscopes (SEM), soft x-ray metrology systems, and the like) can be used to acquire metrology data (e.g. an image) of the patterned substrate. Sometimes the generated metrology data has multiple "channels", i.e. multiple datasets for the same region of the substrate (e.g. the metrology data can comprise two images of the same region of the substrate but acquired using different light of different wavelength).

The acquired metrology data is often further processed using highly specialised algorithms to extract an estimate of a parameter of interest such as an overlay or a focus value. The so-determined parameter of interest can be used to adjust process parameters (e.g. scanner properties, etch process parameters, and the like) which specify the manufacturing process, e.g. to improve performance and yield of the manufacturing process. However, the aforementioned conventional algorithms for processing metrology data have disadvantages. As an example, these algorithms may fail to accurately determine the parameter of interest from multi-channel metrology data when the parameter of interest is "encoded" in complex patterns which differ across channels. As another example, these algorithms may require obtaining a large number of accurate references measurements (e.g. for a training dataset) which is a resource intensive and time-consuming process (e.g. inspecting a large number of target structures with a SEM).

It is therefore desirable to provide improved techniques for processing metrology data.

## SUMMARY

The present invention aims to provide new and useful methods of processing metrology data of a patterned portion of a substrate (patterned using a lithographic apparatus) using a graph neural network which determines, from the metrology data, useful information characterizing aspects of the patterned portion, such as fabrication errors (overlay, tilt, etc.), predictions of metrology data for regions of the patterned portion for which no (or incomplete) metrology data is available, and so forth.

In broad terms, the present invention proposes the use of a graph neural network to exploit spatial and/or semantic relations (or correlations) between different regions of the patterned portion to infer useful information. As described below in more detail, the metrology data is organised into a graph structure, and the resulting graph is then processed with the proposed graph neural network.

According to a first aspect, there is provided a (computer-implemented) method of using a graph neural network to process metrology data of a patterned portion of at least one substrate (e.g. a semiconductor wafer) patterned using at least one lithographic apparatus, to generate characterization information characterizing the patterned portion of the at least one substrate. The patterned portion may be completely contained on a single substrate, or may comprise regions on different substrates (e.g. different semiconductor wafers). Similarly, the entire patterned portion may have been patterned using the same lithographic apparatus, or may have been patterned using multiple lithographic apparatuses (e.g. different instances of nominally identical lithographic apparatuses). For example, the patterned portion may comprise a first region on a first substrate patterned by a first lithographic apparatus, and a second region on a second substrate patterned by a second lithographic apparatus. The patterned portion may comprise at least one target structure (e.g. a semiconductor structure which is an electronic component, such as a transistor, or a logic gate, or a data storage component storing one or more bits of data). In some cases, the patterned portion may comprise a plurality (e.g. hundreds or thousands) of nominally identical target structures arranged in a regular two-dimensional array.

The metrology data may have been generated by one or more metrology systems suitable for inspecting the patterned portion (e.g. using image-based metrology, pupil-based metrology, scanning electron microscopy, or the like). In some cases, the metrology data may comprise data generated by different metrology systems for the same patterned portion (e.g. using different metrology technologies, e.g. optical metrology and SEM-based metrology). In general, the metrology data comprises a subset of metrology data for each of a plurality of regions of the patterned portion. More specifically, the metrology data may comprise an array of numerical values specifying aspects of different regions of the patterned portion. As one example, the metrology data (e.g. when generated using image-based metrology) may comprise image data (e.g. comprising a two-dimensional array of intensity values corresponding to (raw or pre-processed) image data obtained by an image sensor of the metrology system). As another example, the metrology data (e.g. when generated using pupil-based metrology) may comprise an array of numerical values specifying a pupil representation defining a distribution of radiation in a pupil plane of the metrology system.

The method comprises obtaining metrology data of the patterned portion of the at least one substrate, and defining a graph of a graph neural network. The metrology data may be image data, e.g. comprise a respective data element for each of a plurality of pixels in an (e.g. regular) array of pixels (e.g. a two-dimensional array); note that in some cases the array of pixels may include pixels for which there is no data element (e.g. due to a fault in the metrology). The graph is defined to comprise a set of nodes corresponding to respective regions of the patterned portion of the at least one substrate (i.e. each node "represents" a different (e.g. non-overlapping) region of the patterned portion), and edges connecting the nodes. The region that is represented by each node may be selected in many different ways and depending on the specific application in which the proposed method is used. As one example, the patterned portion may comprise a target structure, and each node may represent a different region of the target structure (e.g. in a case when the metrology data comprise image data of the target structure, a node for each pixel of the image data may be defined, or the array of pixels may be partitioned into subsets which each contain multiple pixels (e.g. the subsets may be 2x2, or more generally *nxn* where n is an integer, groups of neighboring pixels) and a node may be defined for each subset). As another example, the patterned portion may comprise a large number of nominally identical target structures, and each node may represent a corresponding one of the target structures. As another example, when there are patterned portions on multiple corresponding substrates fabricated according to the same design (i.e. based on the same design data), a plurality of the nodes may represent corresponding equivalent regions (e.g. target structures) on different ones of the substrates (e.g. instances on different ones of the substrates of targets described by the same design data). It is to be understood these are merely examples, which may optionally be used in any combination, and that many other ways of selecting the regions represented by the nodes can be envisaged by those skilled in the art.

For each node, a corresponding subset of the edges connects the node to one or more corresponding "associated" nodes of the set of nodes. The edges are defined based on at least one of (i) the metrology data and (ii) domain data describing electronic components on the patterned portion of the at least one substrate. Optionally, the edges may be defined based also on further consideration(s) such as geometrical node proximity (i.e. a spatial distance between the respective regions of the patterned portion represented by the nodes) or another spatial characteristic. Optionally, the edges are bi-directional, in the sense that, when any two nodes (a "first node" and a second node) are connected by an edge, the first node is an associated node of the second node and the second node is an associated node of the first node.

As an example, defining edges based on (at least) the metrology data may include defining edges only between nodes corresponding to regions of the patterned portion for which metrology data is available (i.e. the graph formed by the nodes and edges may comprise nodes representing regions of the patterned portion for which no (or incomplete) metrology data is comprised in the obtained metrology data; in this case, these nodes may be omitted (never included in the graph or removed from it), or may not be connected to other nodes). A rule may be applied to specify which edge(s) are defined to connect a node for which metrology data is available to respective (other) associated node(s) for which metrology data is available, e.g. based on the respective spatial positions of the other node(s) in relation to the node as discussed below.

Alternatively or additionally, defining edges based on (at least) the metrology data may include defining edges connecting multiple nodes (e.g. two nodes) based on the value of a function of the metrology data for the multiple nodes, that is, a "semantic" relationship. The function may for example be indicative of a similarity of the respective metrology data of the multiple nodes according to a similarity criterion (e.g. a distance metric). In other words, a given node may be connected by the edges to one or more associated nodes for which the value of the function meets a criterion, e.g. is above a threshold. The criterion may indicate that the corresponding metrology data for the given node and each of the associated node(s) meets a similarity criterion.

As another example, when the patterned portions comprises a plurality of nominally identical target structures, defining edges based on (at least) domain data describing electronic components on the patterned portion of the at least one substrate may include connecting nodes that represent regions of the same target structure, and/or corresponding regions of different target structures. For example, edges can be generated such that nodes corresponding to respective locations on the same substrate at a certain spatial distance from each other have a higher (or lower) chance of being connected by an edge if those locations are part of the same target structure. In another example, in the case of a given node which corresponds to one or more pixels representing data relating to respective position(s) on a target structure, edge(s) may be defined to connect the given node to node(s) which correspond to one or more corresponding pixels representing data relating to respective equivalent position(s) on other instances of target structures which are identical according to the design data.

In some implementations, as noted above, the nodes may be connected by edges created according to at least one criterion based not only on the metrology data and/or the domain data but also on one or more further criteria. One possibility, as noted, is to connect the nodes also according to a rule based on their spatial relationship (i.e. two nodes may be connected if the relative location of the respective regions of the patterned portions satisfies a criterion). More specifically, the edges may further (i.e. in addition to the metrology data and/or the domain data) be created according to a rule based on a distance between the nodes (according to a spatial distance measure, e.g. the Euclidean or Manhattan distance between the respective regions of the patterned portions). For example, the rule may specify that the associated nodes are within a certain distance from the node, and may specify how to select the associated node(s) out of those nodes which are within that distance. As an example, a node may be connected to its k nearest "permissible" neighbors where k is a positive integer (i.e. "permissible" according to the metrology data and/or the domain data). As another example, each node may be connected to up to k "permissible" nodes closest to the node and within a distance from the node that is below a threshold value (i.e. within a threshold radius). In some implementations, both spatial and semantic criteria may be used to further define the edges of the graph.

The method further comprises defining feature data for each node based on a corresponding subset of the metrology data for the corresponding region of the patterned portion of the at least one substrate. In some cases, the feature data of a node may be an embedding of the corresponding subset of the metrology data. More generally, the feature data can be a vector having a numerical value for each of a plurality of elements. Each element of the feature vector for a particular node may specify a different aspect (or "channel") of the respective subset of metrology data for that node. For example, when a node corresponds to a pixel of an RGB image, then the feature vector may have elements for each of the corresponding RGB values. Another example, the feature vector may have elements relating to image-based metrology (e.g. RGB values as mentioned before) and elements relating to SEM-based metrology.

It will be noted that the process described above of generating edges based on semantic relationships, may be considered as a use of the feature data. That is, an instance of defining edges between different nodes based on their semantic relationship may be defining edges based on a similarity metric between the feature data of different nodes. For example, when the feature data comprises a feature vector having RBG values, then nodes may be connected based on a similarity metric of the respective RGB values (e.g. nodes with substantially the same RGB values may be connected). The graph neural network comprises, in addition to the graph of nodes and edges, rules for passing messages between the nodes "along" the edges. The messages are message data based on the feature data of the nodes connected by the edges. Specifically, the method further comprises, at least once, generating, using the graph neural network and for each node, corresponding message data for each of the corresponding one or more associated nodes (the message data for each of the one or more associated nodes is based on the feature data for the respective associated node) and updating, for each node, the feature data for the node based on the corresponding one or more message data, to form updated feature data. Thus, in broad terms, the proposed method implements a "message passing mechanism" which enables a node to receive information (in form of message data) from its associated node(s) and to aggregate that information (e.g. if the node is associated with more than one other node) to update the feature data of the node. The method further comprises generating the characterization information from the updated feature data.

The proposed method can be applied to a wide range of applications and the characterization information may be generated to relate to any one (or more) of many different aspects of the patterned portion (as required by the applications). Examples are described further below.

The inventors have found that it is advantageous to use a graph neural network (GNN) to infer useful information from metrology data (organised into a suitable graph structure). For example, the inventors have found that the proposed method can be used to provide more accurate estimations of overlay errors than traditional methods (e.g. using convolution neural networks), in particular when the metrology data has multi-channels and exhibits (complex) patterns that appear differently (irregularly) across the channels (e.g. spatially shifted, rotated, distorted, and so on). This is because such patterns often contain relevant information (e.g. overlay information) which traditional methods fail to extract but which the proposed method, thanks to the flexible way of defining associations between different regions of the patterned portion(s), can exploit to generate, for example, more accurate overlay predictions.

In some implementations, for each node, each message data may be generated based on the feature data for the node and the feature data for a respective associated node, e.g. by using a trained multilayer perceptron layer to process the feature data for the node and the feature data of a respective associated node. More specifically, for each node, each message data may be generated by processing, using the multilayer perceptron layer, a concatenation of the feature data for the node with a difference between the feature data for the node and the feature data for a respective associated node.

In some implementations, updating the feature data based on the respective one or more message data may comprise, for each node, processing, using an aggregation function, the respective one or more message data to generate aggregated message data, and updating the feature data for the respective node based on the aggregated message data to form updated feature data. As an example, one of the respective one or more message data may be selected as aggregated message data based on a selection criterion (e.g. the message data having a highest corresponding value of a magnitude metric is selected, from one or more message data, as aggregated message data). As another example, the aggregation function may determine, from the respective one or more message data, as aggregated message data, a mean of the one or more message data.

In some implementations, the message data for each of the one or more associated nodes may be based only on the feature data for the respective associated node (i.e. the message data may not depend on the feature data of the node receiving the "message") Updating, for each node, the feature data based on the respective one or more message data may comprise, for each node, determining a mean of the respective one or more message data and updating the feature data for the respective node based on the mean feature data (the mean feature data may be first processed using a trained multilayer perceptron layer to generate processed mean feature data, and the feature data for the respective node may be updated based on the processed mean feature data).

In some implementations, the characterization information may comprise one or more performance parameters of the patterned portion (e.g. a parameter that estimates a manufacturing error of the patterned portion (i.e. a deviation from the desired design) such as an overlay error, a tilt error, and the like). The determined performance parameter may be used to adjust/-correct process parameters of the respective lithographic apparatus.

In some implementations, the method may be performed for each of a set of nominally identically patterned portions (i.e. using respective metrology data), and the method may further comprise processing the updated feature data for each of the patterned portions to infer one or more performance parameters of the set of nominally identically patterned portions (i.e. performance parameter(s) characterizing the entire set of patterned portions rather than individual patterned portions, e.g. an overlay error that is representative for the set of patterned portions).

In some implementations, the patterned portion of the at least one substrate may comprise a plurality of nominally identically patterned target structures, and generating the characterization information from the updated feature data comprises processing the updated graph to generate predicted data for at least one target structure. For example, the predicted data may comprise a predicted performance parameter of the at least one target structure (e.g. a predicted overlay error) and/or predicted metrology data for the at least one target structure (e.g. the predicted data may specify predicted image, SEM, or other type of metrology data).

In some implementations, the method may further comprise defining feature data for each of the edges based on at least one of (i) the metrology data and (ii) the domain data describing electronic components on the patterned portion of the at least one substrate. In this case, the message data is generated based on at least the feature data for the respective associated node and the feature data for the respective edge. The feature data may, for example, be used to generate a corresponding "weight" value for the edge, which is used in generating message data for the corresponding associated node.

In some implementations, the method may perform a plurality of iterations of generating message data for each node and updating the feature data of the nodes. After each iteration, the edges of the graph may be updated (i.e. edges may be added or removed, and/or their respective weights modified) based on the current feature data of the nodes.

According to a second aspect, there is provided a method of using a graph neural network to process metrology data of a patterned portion of at least one substrate patterned using a lithographic apparatus, to generate characterization information characterizing the patterned portion of the substrate. The method comprises obtaining metrology data of the patterned portion of the at least one substrate, defining a graph of a graph neural network, the graph comprising a set of nodes corresponding to respective regions of the patterned portion of the at least one substrate, and edges connecting the nodes. For each node, a corresponding subset of the edges connect the node to one or more corresponding associated nodes of the set of nodes. The method further comprises defining feature data for each node based on a corresponding subset of the metrology data for the corresponding region of the patterned portion of the at least one substrate.

The method further comprises, at least once, generating, using the graph neural network and for each node, corresponding message data for each of the corresponding one or more associated nodes, the message data for each of the one or more associated nodes being based on the feature data for the respective associated node, selecting one of the respective one or more message data based on a selection criterion, and updating, for each node, the feature data for the node based on the selected message data, to form updated feature data.

The method further comprises generating the characterization information from the updated feature data.

It is to be understood the method of the second aspect may be combined with any one of the features of the method of the first aspect.

According to a third aspect, there is provided a computer program product comprising machine-readable instructions which, when the program is executed by a computer, cause the computer to carry out the method of any preceding aspect.

According to a fourth aspect, there is provided a computer system comprising a processor and a data storage device, the data storage device storing program instructions which, when executed by the processor, cause the processor to carry out the method of the first or the second aspect.

## BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 shows example of simulated metrology data;
- Figure 5 depicts schematically an example neural network system which is an embodiment of the invention;
- Figures 6 and 7A-C illustrate example ways of defining associated nodes;
- Figure 8 depicts a flow diagram of an example process of inferring a parameter of interest from metrology data using the neural network system of Figure 5;
- Figure 9 depicts schematically a training system for training the neural network system of Figure 5;
- Figure 10 depicts schematically a further example neural network system which is an embodiment of the invention, and
- Figures 11 to 13 depict experimental data.

## DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

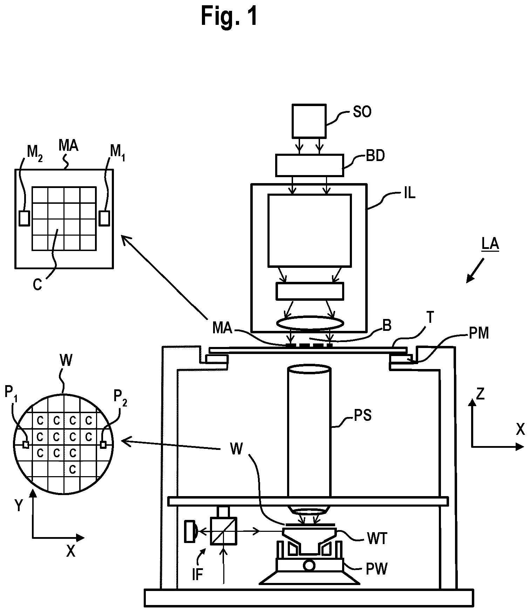

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

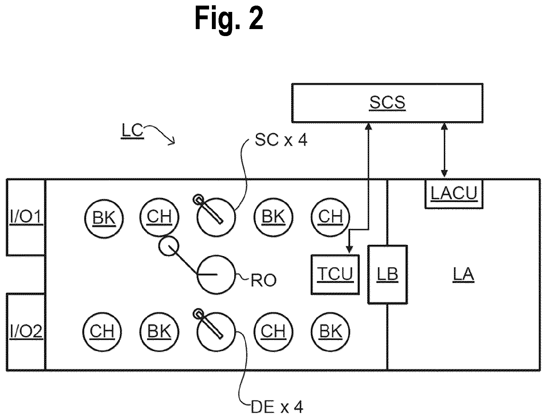

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

*<General text on Holistic Litho>*

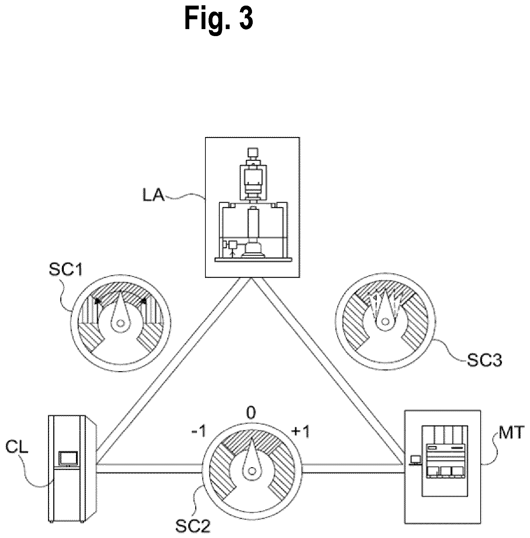

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

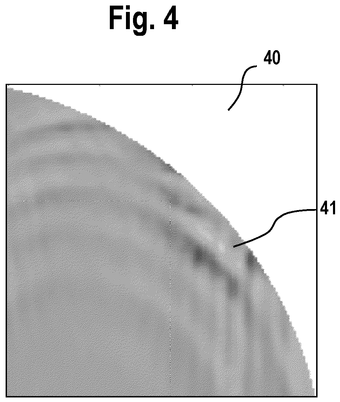

It is often desirable to inspect the patterned substrate using a metrology system, e.g. to determine whether the patterned substrate was fabricated correctly, and/or whether the lithographic apparatus is operating correctly or needs adjusting. Examples of metrology systems include image-based metrology instruments (e.g. micro diffraction based overlay metrology (uDBO) instruments, phase based overlay metrology (pDBO) instruments, optical dark-field microscopes and the like), pupil-based metrology instruments (e.g. scatterometers, soft x-ray metrology instruments), scanning electron microscopes (e.g. single beam or multi-beam SEMs), and the like. The metrology data generated by such a metrology system is usually further processed, using highly-specialised algorithms, to extract parameters of interest (or "performance parameter") such as an overlay error. As noted above, in practice, the metrology data often exhibits complex patterns which may be irregular in shape and appearance across different channels. This is illustrated in Figure 4 which shows simulated image data 40 of a 3D NAND stack target generated using an image-based metrology instrument. It can be seen that the image 40 includes a complex pattern in the form of partial Newton's rings 41 (interference rings). The partial Newton's rings 41 may be caused by optical interference of the light used by the (simulated) image-based metrology when inspecting high stacks (such as a 3D NAND stack). Generally, details of patterns like the partial Newton's rings 41 (e.g. their signal strength, the exact shape and position, and so on) can vary across channels of the metrology data, over time, between wafers, between metrology systems, and so on. As a result, traditional algorithms for processing metrology data often struggle with extracting useful information from such patterns and can produce poor estimates of the parameter of interest (or even completely fail). The inventors have realised that graph neural networks (GNNs) can be used to extract useful information (e.g. overlay information) from patterns such as the Newton's rings of Figure 4 to improve the accuracy of the parameter of interest as described below in more detail.

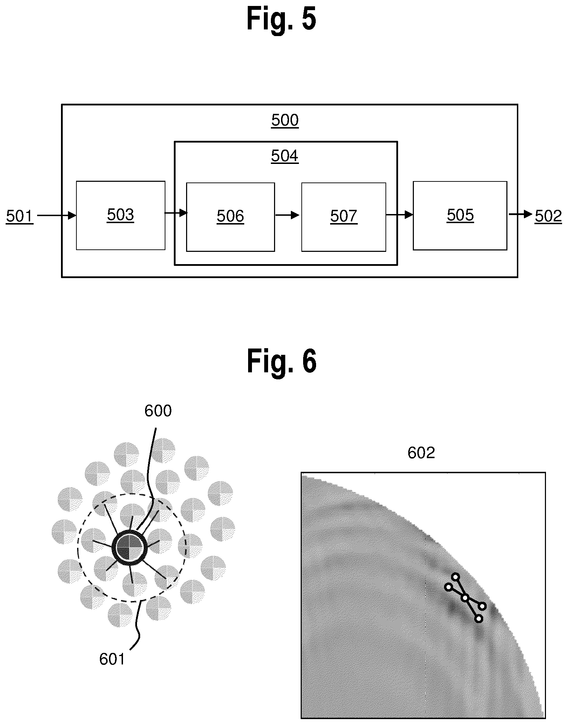

Figure 5 shows a neural network system 500 which, once trained, can process input metrology data 501 generated using a metrology system to generate a parameter of interest "POI" 502 (e.g. an overlay error). The metrology data 501 has been generated by inspecting (using one or more metrology systems) a patterned portion a substrate (e.g. a portion of a semiconductor wafer) patterned using a lithographic apparatus (e.g. the above described lithographic apparatus). In the example of Figure 5, the input metrology data 501 comprises image data (e.g. such as illustrated in Figure 4), i.e. a two-dimensional array of pixel values (each pixel element of array may comprise one or multiple numerical values, e.g. RGB values). Each of the elements of the array is associated with a sample position on the patterned portion. In some cases, the input metrology data 501 comprises multiple "channels" (also referred to as "pupils"), i.e. the input metrology data 501 comprises multiple datasets for the same region of the patterned portion. For example, the metrology data 501 may comprise, in each channel, data generated by the same metrology system but operated with different acquisition settings (such as wavelength and/or polarisation of the light used to inspect the patterned portion, a grating to sensor orientation). In some cases, the different channels of the metrology data 501 can comprise data from generated different metrology technologies (e.g. the metrology data 501 may comprise cannels that include optical metrology data and other channels that include SEM metrology data).

The neural network system 500 comprises a pre-processing module 503, a graph neural network (GNN) 504 (which processes the input metrology data 501) and a parameter-of-interest generation module 505 (which processes the output of the graph neural network to generate the parameter of interest 502 ("PoI 502")). The pre-processing module 503 is configured to receive the input metrology data 501 and to process the received data to generate modified metrology data. More specifically, as mentioned above, the metrology data 501 can include multiple channels comprising data for the same region of the patterned portion, in which case, the different channels may relate to different sample locations within the same region of the patterned portion. For example, this may occur when different channels comprise image data of different respective pixel resolution. The pre-processing module 503 is configured to generate the modified metrology data so that the different channels relate to the same sample points. For example, the pre-processing module 503 may increase the pixel resolution of channels with lower pixel resolution so that each channel relates to the same set of sample points. This may be done by interpolating the pixels using a nearest method or any other suitable up-sampling technique. Thus, the output the pre-processing module 503 (i.e. the modified metrology data which channels have pixels for the same locations on the patterned portion) is then provided to the GNN 504. It is to be understood that in applications where the input metrology data 501 only includes a single channel or where the channels may relate to the same sample locations, the pre-processing module 503 may be omitted and the GNN 504 receives directly the input metrology data 501.

The GNN 504 comprises a graph generation stage 506 and a message passing stage 507. In broad terms, the graph generation stage 506 is configured to receive the modified metrology data from the pre-processing module 503 (or, in cases where the pre-processing module is omitted, the input metrology data 501) and to organize the received data into a graph structure, i.e. into a set of (connected) nodes. More specifically, the graph generation stage 506 is configured to define the graph of the GNN 504 by first defining a set of nodes of the graph corresponding to respective regions of the patterned portion of the substrate. This means that each node of the graph represents a different (e.g. non-overlapping) region of the patterned portion. In the example of Figure 5, the graph generation stage 506 is configured to define one node for each pixel of the image data comprised in the metrology data 501 (i.e. these nodes represent the respective sample locations on the patterned portion imaged by the pixels). The graph generation stage 506 is further configured to generate respective feature data for each node of the graph. More specifically, the graph generation stage 506 generates the feature data for a certain node based on a subset of the (modified) metrology data that corresponds to the sample locations associated with this node. For example, when the graph includes a node for each pixel of the image data of the metrology data 501, the feature data for a certain node may be generated from the corresponding pixel intensity value (or, when the metrology data 501 includes multiple channels, from the corresponding pixel intensity value of each channel). The feature data may be represented as a vector having one or more elements. In some cases, the feature may have an element for each channel of the metrology data 501 (i.e. the dimensionality of the feature vector is equal to the number of channels of the metrology data 501). In the following, the feature vector for the i-th node is denoted $\boldsymbol{x}_i^0$, where the index "0" indicates that the feature vector has not yet been processed by the message passing module 507.

The graph generation stage 506 is further configured to define edges connecting nodes of the graph, i.e. for each node a corresponding subset of the edges is defined that connects the node to one or more corresponding associated nodes of the set of nodes. In general, the graph generation stage 506 can define the edges in many different ways depending on the specific application for which the neural network system 500 is being used. In any case, the graph generation stage 506 is configured to define the edges based on at least one of (i) the metrology data and (ii) domain data describing electronic components on the patterned portion of the substrate. An example of defining edges based on the metrology data is to define edges only between nodes corresponding to regions of the patterned portion for which metrology data is available, i.e. a node may not be connected to a node that represents a region of the patterned portion for which are no (or only incomplete) metrology data is comprised in the metrology data 501 (a node may have no (or only incomplete) corresponding metrology data for various reasons, e.g. in case of faulty sensor (e.g. dead pixel) of the metrology system used to generate the metrology data).

The graph generation stage 506 may take further aspects of the patterned portions and criteria into account when defining the edges, e.g. the spatial proximity of the nodes or the similarity of their feature data. In the example of Figure 5, the graph generation stage 506 is configured to connect a node to the $k$ closest nodes within a certain radius $r$ ($k$ is a positive integer, $k \geq 1$). This is illustrated in Figure 6 which shows a node 600 (having a four-dimensional feature vector, illustrated by the four differently shaded areas) connected to its nearest neighbors which are within the circle 601 of radius r. Figure 6 also indicates, in panel 602, example nodes and edges in the image data of Figure 4. In general, the specific (application depending) criteria or rules (e.g. the value of k) according to which the graph generation stage 506 defines the edges may be predefined or provided by a user (i.e. the edge selection criteria/rules are normally not "learnt" but may be set and iteratively optimized; in other words, the specifics of the edge selection criteria/rules may be considered to correspond to an architectural hyperparameter of the GNN 504).

The message passing stage 507 is configured to implement a "message passing mechanism", i.e. a process in which information between connected nodes of the graph is exchanged. Any suitable message passing mechanism may be employed. In the example of Figure 5, the message passing stage 507 is configured to implement a message passing mechanism in which the feature data of a node is updated based on message data (or simply "messages") from connected nodes. More specifically, the message passing mechanism implemented by the message passing stage 507 is also known as "Edge Convolution" and, in an example, can be expressed as:

$$x_i^{(1)} = \max_{j \in \mathcal{N}(i)} h_\Theta(x_i^{(0)} \,||\, x_j^{(0)} - x_i^{(0)}) \qquad (1)$$

where $\mathrm{x}_\mathrm{i}^{(1)}$ is the feature vector of the i-th node of the graph after the "Edge Convolution" layer is applied, *N*(*i*) is the set of nodes that are associated (i.e. connected) for node i, $h_\Theta$ is a trained Multi-Layer Perceptron (MLP), $\Theta$ denotes the learnable parameters of the MLP, and the symbol || denotes the concatenation of two vectors (therefore the input of the MLP $h_\theta$ is the concatenation of vectors $\mathrm{x}_\mathrm{i}^{(0)}$ and $\mathrm{x}_\mathrm{j}^{(0)} - \mathrm{x}_\mathrm{i}^{(0)}$ ). The output of the MLP $h_\Theta(x_i^{(0)} \,||\, x_j^{(0)} - x_i^{(0)})$ may be considered to be "message" from node j to node i. An aggregation function (e.g. $\max_{j \in \mathcal{N}(i)}$ in Eq. (1)) is applied on the output of $h_\Theta$ to aggregate the messages for node i and to update the feature vector for the node i to obtain an updated feature vector $x_i^{(1)}$. The PoI generation module 505 is configured to process the updated feature vectors (e.g. the features vectors $\{x_i^{(1)}\}$) to generate the PoI 502. To this end, the PoI generation module 505 may be configured to aggregate the updated feature vectors of the graph (e.g. by determining the updated feature vector with a highest magnitude metric, or by determining a mean updated feature vector) to obtain one feature vector for the graph. An additional linear layer may be applied on this aggregated per-graph feature vector to obtain a prediction for the parameter of interest 502, e.g. an overlay prediction.

In some cases, the neural network system 500 may receive respective metrology data for a plurality of nominally identically patterned portions. In these case, each metrology data may be independently processed by pre-processing module 503 and the GNN 504, and the PoI generation module 505 may be configured to process the updated feature vectors for each graph (i.e. for each of the patterned portions) to infer one or more performance parameters of the plurality of nominally identically patterned portions such as an overall overlay error. To this end, the additional linear layer of the PoI generation module 505 may be applied on all aggregated per-graph feature vectors to obtain a prediction for the parameter of interest 502, e.g. an overlay prediction for the entire "population" of patterned portions.

Although the GNN 504 of Figure 5 has been described as employing only one iteration of message passing (i.e. applying the "Edge Convolution", i.e. Eq. (1), to each node only once), it is to be understood that in other implementations, the GNN may be configured to apply several iterations *t=1,... T* of message passing. In this case, the updated feature vector $x_i^{(t)}$ after applying the t-th iteration of message passing may read

$$x_i^{(t)} = \max_{j \in \mathcal{N}(i)} h_\Theta(x_i^{(t-1)} \,||\, x_j^{(t-1)} - x_i^{(t-1)}) \,. \qquad (2)$$

for *t=1,... T* where *T* is an integer. In this case, the POI generation module 504 may operate based on $\{x_i^{(T)}\}$ and optionally updated feature vectors generated for value(s) of t less than 7).

Optionally, in some implementations, the edges of the graph may be modified after each iteration (so that the next round of message passing is based on the new edges). Many ways of modifying the edges exist (e.g. based on a similarity metric of the feature vectors). For example, as noted the edges may be originally defined based on semantic relationships in the feature data, and, in each iteration, the previous edges may be replaced (or supplemented) with new edges defined based on semantic relationships in the updated feature data.

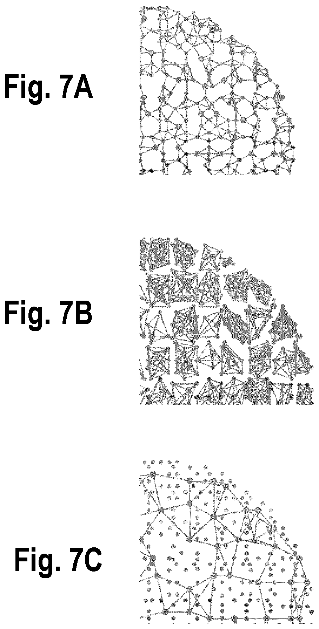

With reference to Figures 7A-C, example edge selection criteria/rules are illustrated for the case where the patterned portion is a semiconductor wafer compromising a plurality of nominally identical targets and each node represents one of the targets. Figure 7A shows a portion of an example graph representing the semiconductor wafer. In this example each node of the graph is connected to its nearest neighbors (k=4) for which metrology data are provided. Thus, in this example, the metrology data for the entire wafer is organized into a single graph. Figure 7B-C show alternative ways of connecting the nodes which employ domain data describing electronic components on the wafer. More specifically, in this example, the wafer is considered to be partitioned into an array of "fields" and the domain data includes information that specifies in which field each target is located (each field may be identified by a respective field row and column number; normally tens or hundreds of targets may be within one field). Figure 7B illustrates an "intra-field" edge selection criteria/rule where the nodes within the same field are connected. Figure 7b illustrates a "field-center" edge selection criteria/rule where a "central" (or representative) node for each field is connected to corresponding nodes of a spatially neighboring field.

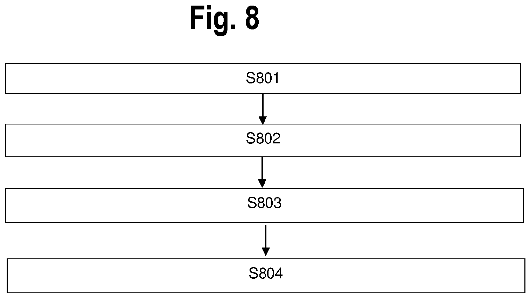

An example process of processing metrology data to generate a parameter of interest will now be described with reference to Figure 8. The process may be implemented using the neural network system 500 of Figure 5 (implemented on one or more computers). In step S801, metrology data of a patterned portion of a substrate is obtained (e.g. received from the metrology system that generated the metrology data). In step 802, the metrology data provided as input to the neural network system 500. The pre-processing module 503 processes the metrology data to generate modified metrology data so that each channel of the modified metrology data includes data for the same sample points on the substrate. Then the GNN 504 organizes the modified metrology data into a graph structure. More specifically, the graph generation stage 506 of the GNN 504 defines nodes (representing locations of the substrate) and edges connecting the nodes. For each node, the graph generation stage 506 generates feature data (e.g. a feature vector) based on a corresponding subset of the modified metrology data. As described above, depending on the specific application, the graph generation stage 506 can define the edges based on many different criteria including spatial (e.g. nearest neighbors) and semantic criteria (e.g. similarity of feature data). In step S803, the message passing stage 507 of the GNN 504, performs at least one round of message passing to update the feature data of each node. To this end, the message passing stage 507 generates, for each node, respective message data based on each node that is connected to the node (e.g. using the trained MLP $h_c$ as described above), aggregates the generated message data (e.g. as described with reference to Eq. (1) above), and updates the feature data for the node based on the aggregated feature data. In step S804, the PoI generation module 505 processes the feature data of each node to generate aggregated feature data for the graph and processes (e.g. using a linear layer) the aggregated feature data to generate, as output of the neural network system 500, an estimation of the parameter of interest.

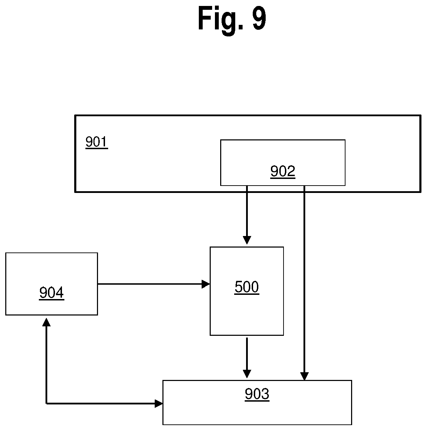

A training system for training the neural network system 500 is now described with reference to Figure 9. The training system comprises training data 901 comprising a plurality of training items 902. The training data 901 is used together with a training engine 903 to iteratively update/optimise the values of a plurality of learnable parameters 904 defining the neural network system 500 (e.g. the parameters 904 comprise parameters defining the GNN 504). These may comprise the the learnable parameters $\Theta$ of the MLP, but may also comprise hyper-parameters such as $k$ and/or $T$. The training system may implement a supervised learning technique.

Each training item may be associated with training metrology data and a corresponding reference value of the parameter of interest (e.g. a value of an overlay error obtained via a SEM measurement). The plurality of training items may be used to train, over a plurality of iterations, the neural network system 500. In the neural network system 500, in each iteration, an update for the parameters 904 is generated by processing a training item 902. To this end, in each iteration, the neural network system 500 processes training metrology data to generate a respective training output (i.e. an estimate of the parameter of interest for the training metrology data). The training output and the corresponding reference value are then processed by the training engine 903 to generate an update for the parameters 904. This generally involves backpropagating gradients of an objective function to update the learnable parameters using any appropriate gradient descent optimization algorithm, e.g. Adam or another optimization algorithm. Generally, the parameters 904 may be updated to reduce a discrepancy (or mismatch) between the training output and the corresponding reference value.

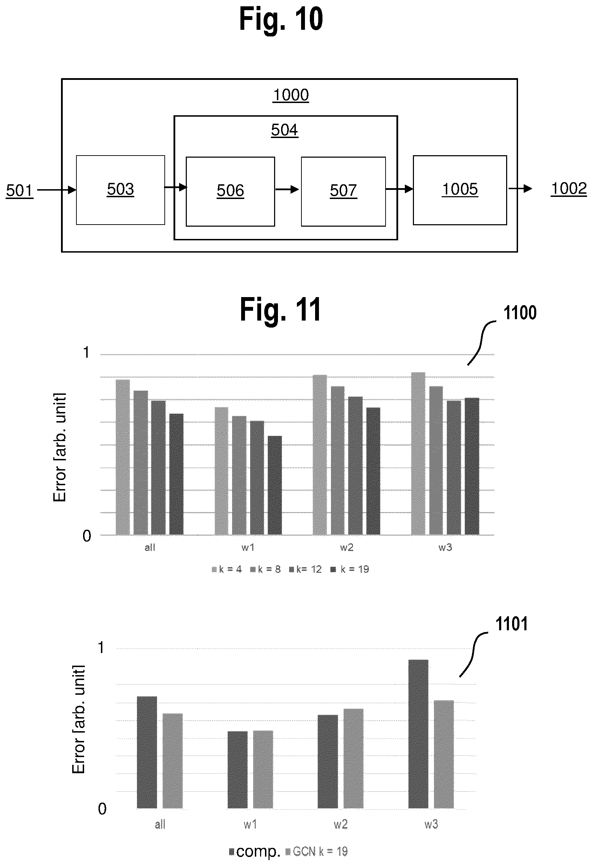

With reference to Figure 10, a variation of the proposed neural network system will now be described. The neural network 1000 is generally similar to the neural network system 500 of Figure 5, in particular in that the neural network 1000 is configured to process the metrology data 501 using the pre-processing module 503 and the GNN 504. In contrast to the neural network system 500, the neural network system 1000 comprises a prediction network that is configured to generate predicted data 1002 for one (or more) of the nodes. In broad terms, the predicted data can be considered to be an "interpolation" of the information comprised in the input metrology data 501 to nodes of the substrate for which no (or only incomplete metrology data is available). More specifically, the predicted data may specify a predicted overlay error for a node for which no (or only incomplete) overlay information or metrology data are available). For example, a SEM-based metrology system may be used to accurately determine an overlay error of a subset of targets on a wafer. In this case, the neural network system 1000 may be used to accurately predict an overlay error for targets which have not been inspected with the SEM but only with a less accurate (but faster or less expensive) metrology technology. The neural network system 1000 can achieve accurate predictions in such cases because the above described message passing mechanism allows the system to exploit cross-channel, cross-node correlations.

As another example, the predicted data may specify predicted metrology data (e.g. metrology data for a specific channel) for a node, e.g. the predicted data may comprise predicted SEM data for a target on the wafer for which no SEM measurements have been performed.

Such predicted metrology data can be used as input (or training dataset) for conventional algorithms (e.g. some conventional algorithms for processing metrology data of semiconductor wafers require SEM data for all targets (which is costly and slow to obtain); in such a case, a few targets can be inspected using a SEM, while the remaining targets are inspected using a more convenient metrology technology; the system of Figure 10 can then be used to predict (or interpolate) the "missing" SEM data so that the (usually highly-specialized) conventional algorithm can be used).

Experimental data obtained with example implementations of the above described systems and method will now be described with reference to Figure 11 to 13. Figure 11 shows experimental results for an example implementations of the system of Figure 5 configured to determine an overlay error from image-based metrology data. In particular, the system processes image data for each of a plurality of targets on the same wafer and generates an overlay error for the wafer. More specifically, the example system has been used to process data from three wafers (denoted "w1", "w2" and "w3"), wherein wafers w2, w3 have been patterned with induced process variations to verify a good generalization of the trained neural network system. Panel 1100 of Figure 11 shows the error (i.e. the difference between the output of the neural network system and "ground-truth" SEM data) for different edge selection rules (k= 4, 8, 12, 19). It can be seen that the error generally decreases with increasing k (i.e. when each node is connected to more nearest neighbors) but, for k> 12, the relative improvement becomes negligible. Panel 1101 of Figure 11 illustrates the performance of the example in comparison to a state-of-the-art algorithm (denoted "comp." in Figure 11) that has been extensively fine-tuned for this use-case (overlay estimation). It can be seen that for w1, w2 the example neural network system outperforms the state-of-the-art algorithm, while for w3 the state-of-the-art algorithm generates more accurate overlay values. Notably, the state-of-the-art algorithm relies on (requires training of) a much larger number of learnable parameters than the example implementation example neural network system (i.e. the state-of-the-art algorithm uses approximately 3*10^6 parameters while the example implementations of the proposed system uses only 3*10^3 parameters). This the present method is more efficient in memory requirements and computational operations, which achieving similar, and in some cases superior, performance. Although not used in this example, it is further noted, that the number of learnable parameters of the proposed system does not change when multiple iterations of message passing mechanisms are used (i.e. using multiple rounds of message passing does not mean that a larger training dataset is required).

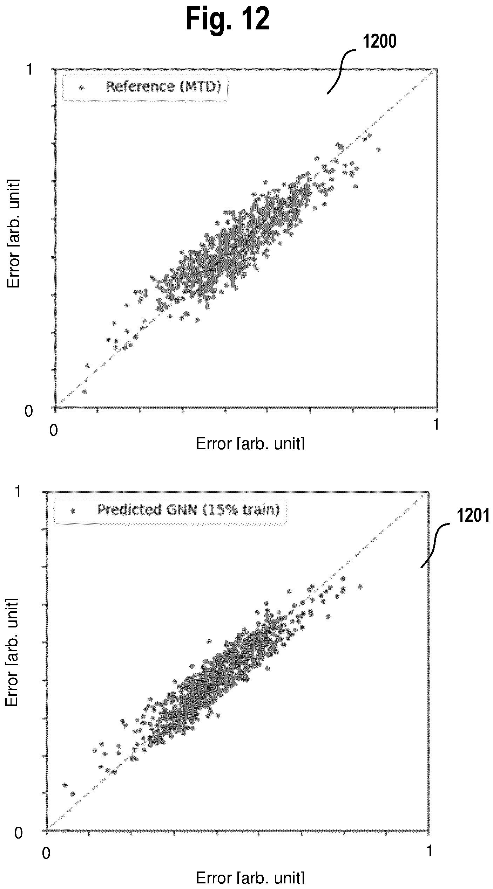

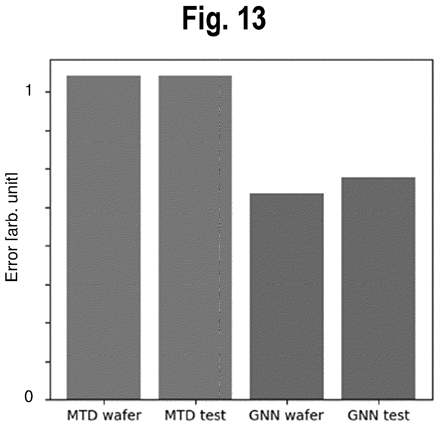

The performance of a second example implementation of the proposed system will now be described with reference to Figures 12 and 13. In this case, the system predicts (or "interpolates") missing overlay values. More specifically, the substrate is a reference wafer with 800 targets of known overlay errors. The second example implementation defines a graph connecting all 800 targets in the wafer by nearest neighbors (k=32). The feature vectors elements to comprise 7 different information channels per target: SWL (single-wavelength) Overlay, Field Column number, Field Row number, Positive Normal Intensity, Positive Complementary Intensity, Negative Normal Intensity and Negative Complementary Intensity.

Panel 1200 of Figure 12 shows a get-set plot of MWL (multi-wavelength) overlay results generated by a conventional metrology algorithm for the 800 targets (compared to the known reference values). Panel 1201, shows the corresponding results for the second example implementation, in which the MWL overlay values for 15% of the nodes (i.e. 120 nodes) are used to predict (taking into the information in other channels) the MWL overlay values for the remaining nodes. It can be seen that the distribution of predicted values in panel 1201 is narrower and closer to the ground-truth values than the distribution of panel 1200. This is further illustrated in Figure 13 which shows the average error for the conventional metrology algorithm (denoted "MTD" in Figure 13) and the second example implementation of the proposed system (denoted "GNN" in Figure 13). The labels "wafer" and "test" refer to respective settings in which the methods are tested on either all of the 800 nodes or only on the 85% of the nodes for which the GNN does not know the MWL overlay value. It can be seen that the average error of the second example implementation of the proposed system is substantially lower than the average error of the conventional method.

Further embodiments are disclosed in the subsequent list of numbered clauses:

1. A method of using a graph neural network to process metrology data of a patterned portion of at least one substrate patterned using at least one lithographic apparatus, to generate characterization information characterizing the patterned portion of the at least one substrate, the method comprising:

   i) obtaining metrology data of the patterned portion of the at least one substrate;
   ii) defining a graph of a graph neural network, the graph comprising a set of nodes corresponding to respective regions of the patterned portion of the at least one substrate, and edges connecting the nodes, wherein for each node a corresponding subset of the edges connect the node to one or more corresponding associated nodes of the set of nodes, and wherein the edges are defined based on at least one of (i) the metrology data and (ii) domain data describing electronic components on the patterned portion of the at least one substrate;
   iii) defining feature data for each node based on a corresponding subset of the metrology data for the corresponding region of the patterned portion of the at least one substrate;

iv) at least once:

a) generating, using the graph neural network and for each node, corresponding message data for each of the corresponding one or more associated nodes, the message data for each of the one or more associated nodes being based on the feature data for the respective associated node; and

b) updating, for each node, the feature data for the node based on the corresponding one or more message data, to form updated feature data; and

v) generating the characterization information from the updated feature data.

2. The method of clause 1, wherein the edges are further defined based on a distance between the nodes.

3. The method of clause 2, wherein each node is connected to up to k nodes closest to the node and within a distance from the node that is below a threshold value, wherein k is a positive integer.

4. The method of clause 1, wherein the edges are further defined based on a similarity metric between the feature data of different nodes.

5. The method of any preceding clause, wherein, for each node, each message data is generated based on the feature data for the node and the feature data for the respective associated node.

6. The method of clause 5, wherein, for each node, each message data is generated, using a multilayer perceptron layer, based on the feature data for the node and the feature data of the respective associated node.

7. The method of clause 6, wherein, for each node, each message data is generated by processing, using the multilayer perceptron layer, a concatenation of the feature data for the node with a difference between the feature data for the node and the feature data for the respective associated node.

8. The method of any preceding clause, wherein updating, for each node, the feature data based on the respective one or more message data comprises, for each node:

processing, using an aggregation function, the respective one or more message data to generate aggregated message data; and

updating the feature data for the respective node based on the aggregated message data to form updated feature data.

9. The method of clause 8, wherein processing, using an aggregation function, the respective one or more message data to generate aggregated message data comprises:

selecting, as aggregated message data, one of the respective one or more message data based on a selection criterion.

10. The method of clause 9, wherein the message data having a highest magnitude metric is selected as aggregated message data.

11. The method of clause 8, wherein processing, using an aggregation function, the respective one or more message data to generate aggregated message data comprises determining, as aggregated message data, a mean of the one or more message data.

12. The method of any one of clauses 1 to 4, wherein the message data for each of the one or more associated nodes is based only on the feature data for the respective associated node, and updating, for each node, the feature data based on the respective one or more message data comprises, for each node:

determining a mean of the respective one or more message data; and

updating the feature data for the respective node based on the mean feature data.

13. The method of clause 12, wherein updating the feature data for the respective node based on the mean feature data comprises:

processing, using a multilayer perceptron layer, the mean feature data to generate processed mean feature data; and

updating the feature data for the respective node based on the processed mean feature data.

14. The method of any preceding clause, wherein the metrology data comprises image data.

15. The method of clause 14, wherein the image data comprises pixels of an image of the patterned portion, and the graph neural network comprises a corresponding node for each pixel of the image.

16. The method of any preceding clause, wherein the patterned portion comprises a plurality of nominally identically patterned target structures, and the graph neural network comprises one corresponding node for each target structure.

17. The method of any preceding clause, wherein the patterned portion comprises portions of different substrates.

18. The method of any preceding clause, wherein the patterned portion comprises portions patterned by different lithographic apparatuses.

19. The method of any preceding clause, wherein the characterization information comprises one or more performance parameters of the patterned portion.

20. The method of any preceding clause, wherein steps i)-v) are performed for each of a plurality of nominally identically patterned portions, the method further comprising:
processing the updated feature data for each of the patterned portions to infer one or more performance parameters of the plurality of nominally identically patterned portions.
21. The method of clause 19 or 20, wherein the one or more performance parameters comprise a performance parameter indicative of an overlay error or a tilt error.
22. The method of any one of clauses 1 to 18, wherein the patterned portion of the at least one substrate comprises a plurality of nominally identically patterned target structures, and wherein generating the characterization information from the updated feature data comprises:
processing the updated graph to generate predicted data for at least one target structure.
23. The method of clause 22, wherein the predicted data specifies a predicted performance parameter of the at least one target structure.
24. The method of clause 22, wherein the predicted data specifies predicted metrology data for the at least one target structure.
25. The method of any preceding clause further comprising defining feature data for each edge based on at least one of (i) the metrology data and (ii) the domain data describing electronic components on the patterned portion of the at least one substrate, and wherein
the message data is generated based on at least the feature data for the respective associated node and the feature data of the respective edge.
26. The method of any preceding clause wherein step iv) is repeated for a plurality of iterations.
27. The method of clause 26, wherein after each iteration, the edges of the graph are updated based on the current feature data of the nodes.
28. A method of using a graph neural network to process metrology data of a patterned portion of at least one substrate patterned using a lithographic apparatus, to generate characterization information characterizing the patterned portion of the substrate, the method comprising:

i) obtaining metrology data of the patterned portion of the at least one substrate;
ii) defining a graph of a graph neural network, the graph comprising a set of nodes corresponding to respective regions of the patterned portion of the at least one substrate, and edges connecting the nodes, wherein for each node a corresponding subset of the edges connect the node to one or more corresponding associated nodes of the set of nodes;
iii) defining feature data for each node based on a corresponding subset of the metrology data for the corresponding region of the patterned portion of the at least one substrate;
iv) at least once:

a) generating, using the graph neural network and for each node, corresponding message data for each of the corresponding one or more associated nodes, the message data for each of the one or more associated nodes being based on the feature data for the respective associated node;
b) selecting one of the respective one or more message data based on a selection criterion; and
c) updating, for each node, the feature data for the node based on the selected message data, to form updated feature data; and
d) generating the characterization information from the updated feature data.

29. A computer program product comprising machine-readable instructions which, when the program is executed by a computer, cause the computer to carry out the method of any preceding clause.
30. A computer system comprising a processor and a data storage device, the data storage device storing program instructions which, when executed by the processor, cause the processor to carry out the method of any one of clauses 1 to 28.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

For example, in some implementations, the neural network system may further define feature data for each of the edges. In this case, the message passing mechanism may update the feature data of the nodes based also on the feature data of the relevant edges. For example, the feature data of the edges may be defined based on the distance of the relevant nodes.

## Claims

**1.** A method of using a graph neural network to process metrology data of a patterned portion of at least one substrate patterned using at least one lithographic apparatus, to generate characterization information characterizing the patterned portion of the at least one substrate, the method comprising:

i) obtaining metrology data of the patterned portion of the at least one substrate;
ii) defining a graph of a graph neural network, the graph comprising a set of nodes corresponding to respective regions of the patterned portion of the at least one substrate, and edges connecting the nodes, wherein for each node a corresponding subset of the edges connect the node to one or more corresponding associated nodes of the set of nodes, and wherein the edges are defined based on at least one of (i) the metrology data and (ii) domain data describing electronic components on the patterned portion of the at least one substrate;
iii) defining feature data for each node based on a corresponding subset of the metrology data for the corresponding region of the patterned portion of the at least one substrate;
iv) at least once:

a) generating, using the graph neural network and for each node, corresponding message data for each of the corresponding one or more associated nodes, the message data for each of the one or more associated nodes being based on the feature data for the respective associated node; and
b) updating, for each node, the feature data for the node based on the corresponding one or more message data, to form updated feature data; and

v) generating the characterization information from the updated feature data.

**2.** The method of claim 1, wherein the edges are further defined based on a distance between the nodes.

**3.** The method of claim 1, wherein the edges are further defined based on a similarity metric between the feature data of different nodes.

**4.** The method of any preceding claim, wherein, for each node, each message data is generated based on the feature data for the node and the feature data for the respective associated node.

**5.** The method of any preceding claim, wherein updating, for each node, the feature data based on the respective one or more message data comprises, for each node:

processing, using an aggregation function, the respective one or more message data to generate aggregated message data; and
updating the feature data for the respective node based on the aggregated message data to form updated feature data.

**6.** The method of any one of claims 1 to 3, wherein the message data for each of the one or more associated nodes is based only on the feature data for the respective associated node, and updating, for each node, the feature data based on the respective one or more message data comprises, for each node:

determining a mean of the respective one or more message data; and
updating the feature data for the respective node based on the mean feature data.

**7.** The method of any preceding claim, wherein the metrology data comprises image data.

**8.** The method of any preceding claim, wherein the patterned portion comprises a plurality of nominally identically patterned target structures, and the graph neural network comprises one corresponding node for each target structure.

**9.** The method of any preceding claim, wherein the patterned portion comprises portions of different substrates.

**10.** The method of any preceding claim, wherein the characterization information comprises one or more performance parameters of the patterned portion.

**11.** The method of any preceding claim, wherein steps i)-v) are performed for each of a plurality of nominally identically patterned portions, the method further comprising:
processing the updated feature data for each of the patterned portions to infer one or more performance parameters of the plurality of nominally identically patterned portions.

**12.** The method of any preceding claim further comprising defining feature data for each edge based on at least one of (i) the metrology data and (ii) the domain data describing electronic components on the patterned portion of the at least one substrate, and wherein
the message data is generated based on at least the feature data for the respective associated node and the feature data of the respective edge.

**13.** A method of using a graph neural network to process metrology data of a patterned portion of at least one substrate patterned using a lithographic apparatus, to generate characterization information characterizing the patterned portion of the substrate, the method comprising:

i) obtaining metrology data of the patterned portion of the at least one substrate;
ii) defining a graph of a graph neural network, the graph comprising a set of nodes corresponding to respective regions of the patterned portion of the at least one substrate, and edges connecting the nodes, wherein for each node a corresponding subset of the edges connect the node to one or more corresponding associated nodes of the set of nodes;
iii) defining feature data for each node based on a corresponding subset of the metrology data for the corresponding region of the patterned portion of the at least one substrate;
iv) at least once:

a) generating, using the graph neural network and for each node, corresponding message data for each of the corresponding one or more associated nodes, the message data for each of the one or more associated nodes being based on the feature data for the respective associated node;
b) selecting one of the respective one or more message data based on a selection criterion; and
c) updating, for each node, the feature data for the node based on the selected message data, to form updated feature data; and
d) generating the characterization information from the updated feature data.

**14.** A computer program product comprising machine-readable instructions which, when the program is executed by a computer, cause the computer to carry out the method of any preceding claim.

**15.** A computer system comprising a processor and a data storage device, the data storage device storing program instructions which, when executed by the processor, cause the processor to carry out the method of any one of claims 1 to 13.

Fig. 1

SO
BD
IL
LA
MA
$M_2$
$M_1$
C
MA
B
T
PM
W
$P_1$
$P_2$
C C C C
C C C C
C C C
C
PS
Z
X
W
Y
X
WT
IF
PW

Fig. 2

SCS
LC
SC x 4
LACU
I/O1
BK
CH
BK
CH
RO
TCU
LB
LA
I/O2
CH
BK
CH
BK
DE x 4

# Fig. 3

LA
SC1
SC3
0
-1
+1
CL
MT
SC2

Fig. 4

40
41

Fig. 5

500
504
501
503
506
507
505
502

Fig. 6

600
602
601

Fig. 7A

Fig. 7B

Fig. 7C

Fig. 8

S801
S802
S803
S804

# Fig. 9

901
902
904
500
903

# Fig. 10

1000
504
501
503
506
507
1005
1002

# Fig. 11

1100
1
0
Error [arb. unit]
all
w1
w2
w3
k = 4
k = 8
k= 12
k = 19

1101
1
0
Error [arb. unit]
all
w1
w2
w3
comp.
GCN k = 19

# Fig. 12

1200
1
Reference (MTD)
Error [arb. unit]
0
0
1
Error [arb. unit]
1
Predicted GNN (15% train)
1201
Error [arb. unit]
0
0
1
Error [arb. unit]

Fig. 13

1
0
Error [arb. unit]
MTD wafer
MTD test
GNN wafer
GNN test

Europäisches
Patentamt
European
Patent Office
Office européen
des brevets

# EUROPEAN SEARCH REPORT

Application Number
EP 24 21 6949

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/211722 A1 (BUHMANN ALEXANDER [DE] ET AL) 27 June 2024 (2024-06-27) | 1,2,4-7, 9,10, 12-15 | INV. G03F7/00 |
| A | * paragraph [0002] - paragraph [0061] * * figure 1 * ----- | 3,8,11 | |

TECHNICAL FIELDS SEARCHED (IPC)

G03F

The present search report has been drawn up for all claims

| Place of search | Date of completion of the search | Examiner |
|---|---|---|
| Munich | 16 June 2025 | Meixner, Matthias |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 24 21 6949

This annex lists the patent family members relating to the patent documents cited in the above-mentioned European search report. The members are as contained in the European Patent Office EDP file on
The European Patent Office is in no way liable for these particulars which are merely given for the purpose of information.

16-06-2025

| Patent document cited in search report | Publication date | Patent family member(s) | Publication date |
|---|---|---|---|
| US 2024211722 A1 | 27-06-2024 | JP 2024083203 A | 20-06-2024 |
| | | US 2024211722 A1 | 27-06-2024 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6952253 B